Europäisches Patentamt

European Patent Office

Office européen des brevets

(19)

(11) **EP 1 067 556 B1**

(12) **FASCICULE DE BREVET EUROPEEN**

(45) Date de publication et mention
de la délivrance du brevet:
**19.10.2005 Bulletin 2005/42**

(51) Int Cl.⁷: **G11C 7/18**, G11C 11/419

(21) Numéro de dépôt: **00401972.5**

(22) Date de dépôt: **07.07.2000**

(54) **Mémoire RAM**

RAM Speicher

RAM memory

(84) Etats contractants désignés:
**AT BE CH CY DE DK ES FI FR GB GR IE IT LI LU
MC NL PT SE**

(30) Priorité: **09.07.1999 FR 9908947**

(43) Date de publication de la demande:
**10.01.2001 Bulletin 2001/02**

(73) Titulaire: **CSEM Centre Suisse d'Electronique et
de
Microtechnique S.A. - Recherche et
Développement
2007 Neuchâtel (CH)**

(72) Inventeurs:
• **Masgonty, Jean-Marc
2074 Marin (CH)**
• **Cserveny, Stefan
1066 Epalinges (CH)**
• **Piguet, Christian
2000 Neuchatel (CH)**
• **Robin, Frédéric
2206 Geneveys S/Coffrane (CH)**

(74) Mandataire: **Caron, Gérard et al
Cabinet JP Colas
37 avenue Franklin D. Roosevelt
75008 Paris (FR)**

(56) Documents cités:
US-A- 5 729 501          US-A- 5 850 367
US-A- 5 901 079          US-A- 5 966 320

• HIROYUKI HARA ET AL: "0.5-UM
2M-TRANSISTOR BIPNMOS CHANNELLESS
GATE ARRAY" IEEE JOURNAL OF
SOLID-STATE CIRCUITS,US,IEEE INC. NEW
YORK, vol. 26, no. 11, 1 novembre 1991
(1991-11-01), pages 1615-1620, XP000266671
ISSN: 0018-9200

# Description

La présente invention est relative aux mémoires vives du type désigné généralement par le sigle anglais SRAM (pour Static Random Access Memory ou Mémoire Statique à Accès Aléatoire).

Une telle mémoire comporte une matrice formée par des colonnes et des rangées de cellules de mémoire. Les rangées de cellules peuvent être adressées par un décodeur d'adresses, tandis que les opérations de lecture/écriture sont effectuées sur les colonnes à l'aide de deux lignes de bits par colonne, l'une des lignes de bits étant désignée par "ligne de bits directe" et l'autre par "ligne de bits inverse".

Pour effectuer un cycle de lecture dans une telle mémoire RAM, les lignes de bits doivent être portées à un niveau logique prédéterminé, c'est à dire que, selon le cas, elles doivent être chargées ou déchargées. Or, comme leur capacité propre est importante, cette opération de charge ou de décharge demande du temps, de sorte que la durée d'un cycle de lecture est importante. Par ailleurs, la consommation d'énergie de la mémoire est relativement élevée.

Pour réduire ces inconvénients, il est déjà connu, par exemple par US 5 729 501, de fractionner au moins l'une des lignes de bits en une pluralité de tronçons connectés respectivement aux entrées d'une porte logique de sortie.

De la sorte, il est possible de réduire la capacité des lignes de bits et ainsi d'économiser de l'énergie à chaque opération d'écriture ou de lecture.

L'invention a pour but de perfectionner l'agencement de mémoire de la technique antérieure en proposant une mémoire dont la consommation est encore réduite davantage et dont le dimensionnement des transistors peut être plus favorable.

Elle a donc pour objet une mémoire RAM présentant les caractéristiques de la revendication 1.

Des particularités avantageuses de l'objet de l'invention sont définies dans les sous-revendications.

D'autres caractéristiques et avantages de l'invention apparaîtront au cours de la description qui va suivre, donnée uniquement à titre d'exemple et faite en se référant aux dessins annexés sur lesquels:

- la figure 1 est un schéma d'une cellule d'une mémoire RAM selon l'invention;
- la figure 2 est un schéma partiel du mode de réalisation préféré d'une mémoire RAM selon l'invention.

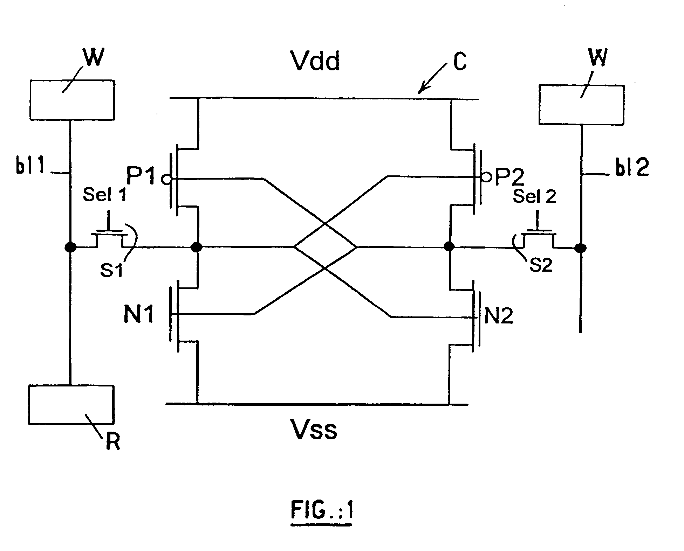

La figure 1 représente un exemple de cellule C pour une mémoire RAM. Elle est formée de deux inverseurs, réalisés sous la forme d'un montage en parallèle de deux transistors en série de types p et n. Les potentiels d'alimentation $V_{dd}$ et $V_{ss}$ sont appliqués aux bornes de ce montage en parallèle.

Plus précisément, les branches de la cellule comprennent un transistor p, respectivement P1 et P2, en série avec un transistor n respectivement N1 et N2, les grilles des transistors étant reliées entre elles par des connexions croisées comme représenté sur la figure 1.

La cellule C comprend également des transistors de sélection S1 et S2 qui sont destinés à assurer respectivement la connexion des branches de la cellule à des lignes de bits orientées selon les colonnes de la matrice de mémoire et appelées l'une (bl1) "ligne de bits directe" et l'autre (bl2) "ligne de bits inverse". La commande des transistors S1 et S2 est assurée, en commun pour toutes les cellules d'une rangée de la mémoire et de façon connue en soi, par l'intermédiaire de l'adressage qui engendre les signaux de sélection Sel1 et Sel2.

Les opérations de lecture et d'écriture des données dans les cellules sont effectuées par l'intermédiaire des lignes de bits bll et bl2 par des moyens de commande de lecture R et d'écriture W, symbolisés sur la figure 1 par des rectangles, étant entendu que selon l'invention, la ligne de bits bl1 est commandée en lecture et en écriture et la ligne de bits bl2 en écriture seulement.

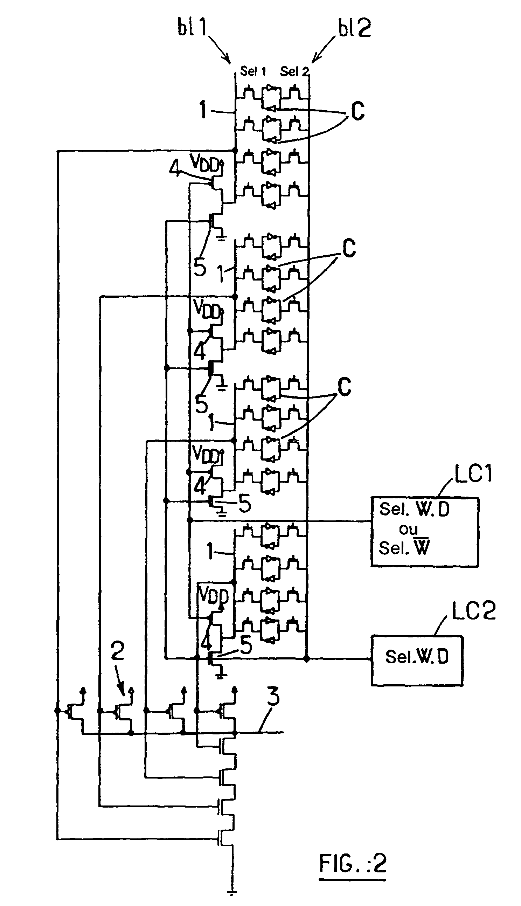

La figure 2 représente plus en détail le mode de réalisation préféré de la mémoire selon l'invention, et plus précisément l'organisation d'une seule colonne de cette mémoire RAM, la colonne étant formée d'un grand nombre de cellules C. Pour simplifier la figure, les cellules C sont symbolisées par deux inverseurs en tête-bêche et on n'en a dessiné qu'un nombre réduit. La mémoire peut comprendre une juxtaposition d'un très grand nombre de ces colonnes.

On voit que les cellules C sont raccordées à des lignes de bits directe et inverse bl1 et bl2. Dans le présent mode de réalisation, la ligne de bits bl1 est fractionnée en une pluralité de tronçons de ligne 1. A chaque tronçon de ligne 1 est connecté un groupe de cellules C, celles-ci étant par ailleurs toutes connectées à l'autre ligne de bits bl2 qui, elle, n'est ici pas fractionnée. Bien que cela ne soit pas visible sur la figure, le fractionnement en tronçons est réalisé pour des groupes de cellules équivalents situés dans les mêmes rangées de la matrice de mémoire.

Selon une caractéristique essentielle de l'invention, on s'affranchit de la symétrie des cellules de la mémoire. En effet, la commande de chaque cellule adressée est réalisée de telle façon que l'opération d'écriture dans une cellule se fasse à travers les deux transistors de sélection S1 et S2, mais que l'opération de lecture dans une cellule ne se fasse qu'à travers l'un des transistors S1 ou S2 seulement, selon la logique adoptée pour la mémoire.

Cette caractéristique de l'invention est illustrée dans son principe sur la figure 1, où l'on voit que, pour un exemple de logique choisie, le transistor de sélection S1 est activé en écriture et en lecture, mais que le transistor S2 ne l'est qu'en écriture.

Cette façon de commander une cellule procure plusieurs avantages. Tout d'abord, l'écriture étant faite des deux côtés de chaque cellule, elle peut être réalisée à une tension $V_{DD}$ basse. Par ailleurs, comme la lecture ne se fait que d'un seul côté, la consommation d'énergie est réduite du fait que la capacité en jeu est plus faible. Enfin, il n'est plus nécessaire que la cellule soit symétrique, les transistors pouvant avoir des dimensions minimales et le transistor S1 pouvant être dimensionné indépendamment des autres transistors de la cellule, en fonction de la vitesse requise. Le transistor S2 étant petit, la capacité sur la ligne de bits inverse est faible pendant l'écriture, ce qui réduit encore davantage la consommation. On peut également augmenter la taille du transistor S1 pour une dimension donnée du transistor N1. Ceci permet d'augmenter la vitesse de lecture, un optimum du rapport des tailles pouvant être proche de 1, voire égal à 1.

Selon un exemple de réalisation de l'invention, on peut ainsi réaliser une cellule dans laquelle $T_{N2}=T_{N1}/3{,}2$, $T_{S1}=T_{N1}$ et $T_{S2}=T_{N2}=T_{N1}/3{,}2$.

Les tronçons 1 de la ligne de bits bl1 sont connectés aux entrées d'une porte de sortie 2 assurant la présentation des signaux de lecture sur sa sortie 3. La fonction logique de cette porte est avantageusement NON-ET, avec la logique choisie pour cette mémoire, mais une autre fonction peut, bien entendu, être choisie si cette logique adoptée est différente.

Chacun des tronçons 1 de la ligne de bits bll fractionnée est en outre connecté à un transistor 4 de type p assurant sa précharge et à un autre transistor de commande 5 de type n.

Les grilles des transistors 4 sont connectées ensemble à une première logique de commande LC1 assurant, selon qu'il s'agit d'une opération d'écriture ou de lecture, la fonction Sel.W.D ou Sel. $\overline{W}$, où "Sel" est le signal de sélection, "W" le signal d'écriture, $\overline{W}$ le signal de lecture, et "D" le signal de donnée, le symbole "." représentant la fonction logique "ET".

Les grilles des transistors 5 sont connectées ensemble à une seconde logique de commande LC2 assurant la fonction logique Sel.W.D, qu'il s'agisse d'une opération d'écriture ou de lecture.

Dans cette mémoire, les tronçons 1 de la ligne de bits bll sont toujours préchargés à $V_{DD}$ lorsque aucune cellule de la colonne n'est adressée, le transistor p 4 étant conducteur avec sa grille portée à $V_{SS}$. C'est donc une situation d'attente pour chaque colonne de la mémoire.

Si une cellule d'une colonne est sélectionnée, le signal Sel passe au niveau haut. S'il s'agit d'une écriture, le signal W passe au niveau haut, le transistor 4 du tronçon 1 concerné par la cellule adressée établissant alors le niveau du potentiel $V_{DD}$ sur ce tronçon 1, si le signal de donnée D est bas. Par contre, si le signal de donnée D est haut, le transistor 5 fait passer le tronçon 1 au potentiel $V_{SS}$. La ligne de bits correspondante reçoit la valeur complémentaire du signal de donnée D.

La condition d'attente de la ligne de bits bl2 est celle du niveau bas. Elle n'est portée au niveau haut que si un signal de donnée est haut pendant l'écriture dans une cellule de la colonne considérée. En effet, cette ligne n'est reliée à une cellule adressée par le transistor de sélection S2 que pendant l'écriture. Par contre, pendant la lecture, ce transistor n'est pas activé, ce qui réduit la consommation.

Il est à noter que la commande d'écriture et de lecture telle qu'elle vient d'être décrite peut également s'appliquer à des mémoires RAM dont dans chaque colonne, les lignes de bits ne sont fractionnées ni l'une, ni l'autre, une telle mémoire pouvant alors comprendre des cellules asymétrique avec des rapports de dimensions tels que décrits ci-dessus.

D'une façon générale, l'invention n'est pas limitée aux types de logique décrits.

## Revendications

**1.** Mémoire RAM comportant une matrice composée de cellules agencées en rangées et en colonnes et dans laquelle les cellules sont adressables par rangées, chaque cellule d'une rangée étant connectée à des première et deuxième lignes de bits dont au moins ladite première ligne (bl1) est fractionnée, ladite première ligne de bits fractionnée présentant une pluralité de tronçons (1) connectés respectivement aux entrées d'une porte logique de sortie (2,3),

la mémoire comprenant également des moyens de commande de lecture/écriture,

cette mémoire étant **caractérisée en ce que** lesdits moyens de commande (LC1, LC2) de lecture/écriture sont agencés pour directement ou indirectement appliquer, sélectivement selon qu'il s'agit d'une opération d'écriture ou de lecture, à chacune desdites première et deuxième lignes de bits (bl1, b12), les fonctions logiques suivantes :

Sel.((W.D) ou $\overline{W}$)) sur ladite première ligne de bits (bl1), pendant que Sel.W.D est appliqué sur lesdites première et deuxième lignes de bits (bl1, bl2), et

"Sel" étant un signal de sélection de cellule représentatif de l'adressage, "W" étant la commande d'écriture, $\overline{W}$ étant la commande de lecture, "D" étant la donnée à écrire dans la cellule adressée et "." étant le symbole de la fonction ET.

**2.** Mémoire RAM selon la revendication 1, **caractérisée en ce que** chacun desdits tronçons (1) est raccordé à deux transistors (4, 5) de types de conductivité opposés, et **en ce que** lesdites fonctions logiques sont appliquées sélectivement sur les grilles desdits transistors.

**3.** Mémoire RAM selon l'une quelconque des revendications 1 et 2, dans laquelle chacune desdites cellules comprend deux branches composées chacune de deux transistors en série de types de conductivité opposés (P1, N1, P2, N2) dont les grilles sont connectées ensemble, respectivement par des conducteurs croisés, chaque cellule comprenant également des transistors de sélection (S1, S2) connectés respectivement auxdites branches et lesdites lignes de bits pour permettre la sélection de la cellule en fonction de l'adressage de la mémoire, **caractérisée en ce que** les transistors (P1, N1) de la branche susceptible d'être connectée au tronçon (1) de ligne de bits correspondant, ont une taille supérieure à celle des transistors (P2, N2) de l'autre branche.

**4.** Mémoire RAM selon l'une quelconque des revendications 1 à 3, **caractérisée en ce que** chacun desdits tronçons (1) est connecté à des moyens de précharge (4).

**5.** Mémoire RAM selon l'une quelconque des revendications 1 à 4, **caractérisée en ce que** ladite porte de sortie (2, 3) est une porte NON-ET.

**Patentansprüche**

**1.** RAM-Speicher, umfassend eine Matrix, die aus Zellen besteht, die in Zeilen und Spalten angeordnet sind und in der die Zellen zeilenweise adressierbar sind, wobei jede Zelle einer Zeile mit einer ersten und zweiten Bitreihe verbunden ist, von denen mindestens die erste Reihe (b11) aufgeteilt ist, wobei die erste Zeile aufgeteilter Bits eine Vielzahl von Abschnitten (1) umfasst, die jeweils mit den Eingängen eines logischen Ausgangsgatters (2, 3) verbunden sind,
wobei der Speicher auch Mittel zum Lese- / Schreibbefehl umfasst,
wobei dieser Speicher **dadurch gekennzeichnet ist, dass** die Mittel zum Lese- / Schreibbefehl (LC1, LC2) so angeordnet sind, dass sie unmittelbar oder mittelbar, je nachdem, ob es sich um eine Schreiboder Leseoperation handelt, an jede der ersten und zweiten Bitreihen (b11, b12) die folgenden Logikfunktionen anlegen:

Sel. ((W.D) oder $\overline{W}$)) auf die erste Bitreihe (b11), während Sel.W.D an die erste und zweite Bitreihe (b11, b12) angelegt wird, wobei

"Sel" ein Signal zur Zellenselektion ist, das die Adressierung repräsentiert, "W" der Schreibbefehl, "$\overline{W}$" der Lesebefehl, "D" der in die adressierte Zelle hineinzuschreibende Datensatz und "." das Symbol der Funktion UND.

**2.** RAM-Speicher nach Anspruch 1, **dadurch gekennzeichnet, dass** jeder der Abschnitte (1) mit zwei Transistoren (4, 5) von entgegengesetztem Leitfähigkeitstyp verbunden ist, und **dadurch**, dass die Logikfunktionen selektiv an die Gates der Transistoren angelegt werden.

**3.** RAM-Speicher nach einem der Ansprüche 1 und 2, bei dem jede der Zellen zwei Zweige umfasst, die jeweils aus zwei in Reihe geschalteten Transistoren von entgegengesetztem Leitfähigkeitstyp (P1, N1, P2, N2) bestehen, deren Gates zusammen geschaltet sind, jeweils durch Kreuzleiter, wobei jede Zelle auch Selektionstransistoren (S1, S2) umfasst, die jeweils an die Zweige und die Bitreihen angeschlossen sind, um die Selektion der Zelle je nach Adressierung des Speichers zu ermöglichen, **dadurch gekennzeichnet, dass** die Transistoren (P1, N1) des Zweigs, der dafür geeignet ist, an den Abschnitt (1) der entsprechenden Bitreihe angeschlossen zu werden, eine größere Größe aufweisen als die Transistoren (P2, N2) des anderen Zweigs.

**4.** RAM-Speicher nach einem der Ansprüche 1 bis 3, **dadurch gekennzeichnet, dass** jeder der Abschnitte (1) mit Mitteln zum Vorladen (4) verbunden ist.

**5.** RAM-Speicher nach einem der Ansprüche 1 bis 4, **dadurch gekennzeichnet, dass** das Ausgangsgatter (2, 3) ein NICHT-UND-Gatter ist.

**Claims**

**1.** A random access memory comprising a matrix made up of cells arranged in rows and in columns and in which said cells are adapted to be addressed row by row, each cell of a row being connected to first and second bit lines, at least said first bit line (bl1) being subdivided, said subdivided first bit line comprising a plurality of sections (1) connected to respective inputs of an output logic gate (2,3),
said memory including also read/write control means
**characterized in that** said read/write control means (LC1, LC2) are adapted to apply the following logic functions to each of said first and second bit lines (bl1, bl2) directly or indirectly and selectively, according to whether a required operation is a write or a read :

Sel.((W.D) or $\overline{W}$)) being applied to the first bit line (bl1), whilst Sel.W.D is applied to both the first and second bits lines (bl1, bl2),

where "Sel" is a cell selection signal representative of the address, "W" is the write control, $\overline{W}$ is the read control, "D" is the data to be written into the addressed cell and "." indicates the AND function.

2. The random access memory claimed in claim 1, **characterized in that** each section (1) is connected to two transistors (4,5) of opposite conductivity type and said logic functions are selectively applied to gates of said transistors.

3. The random access memory claimed in claim 1, wherein each cell has two branches each made up of two transistors of opposite conductivity type in series (P1, N1, P2, N2) with their gates cross-connected, each cell also comprising selector transistors (S1, S2) connected respectively to said branches and said bit lines to enable selection of said cell on addressing said memory, **characterized in that** said transistors (P1, N1) of the branch which is adapted to be connected to the corresponding bit line section (1) are larger than said transistors (P2, N2) of the other branch.

4. The random access memory claimed in claim 1 wherein each section (1) is connected to precharging means (4).

5. The random access memory claimed in claim 1 wherein said output (2, 3) gate is a NAND gate.

FIG.:1

FIG.:2